(19) **Europäisches Patentamt**
**European Patent Office**
**Office européen des brevets**

(11) **EP 2 188 407 B1**

(12) **FASCICULE DE BREVET EUROPEEN**

(45) Date de publication et mention
de la délivrance du brevet:
**29.06.2011 Bulletin 2011/26**

(21) Numéro de dépôt: **08835347.9**

(22) Date de dépôt: **11.09.2008**

(51) Int Cl.:
***C23C 14/06*** (2006.01)   ***C23C 14/48*** (2006.01)
***H01L 21/3215*** (2006.01)

(86) Numéro de dépôt international:
**PCT/FR2008/051623**

(87) Numéro de publication internationale:
**WO 2009/044083 (09.04.2009 Gazette 2009/15)**

(54) **PROCEDE DE REDUCTION DE LA POROSITE D'UN DEPOT METALLIQUE PAR BOMBARDEMENT IONIQUE**

VERFAHREN ZUR REDUZIERUNG DER POROSITÄT EINER METALLABLAGERUNG DURCH IONENBOMBARDIERUNG

METHOD FOR REDUCING POROSITY OF A METAL DEPOSIT BY IONIC BOMBARDMENT

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **11.09.2007 FR 0706341**

(43) Date de publication de la demande:
**26.05.2010 Bulletin 2010/21**

(73) Titulaire: **Quertech Ingenierie**
**14000 Caen (FR)**

(72) Inventeur: **BUSARDO, Denis**
**F-14510 Gonneville-sur-Mer (FR)**

(74) Mandataire: **Cabinet Plasseraud**
**52, rue de la Victoire**
**75440 Paris Cedex 09 (FR)**

(56) Documents cités:
**EP-A- 1 595 972    WO-A-2005/085491**
**FR-A- 2 899 242**

- **CHUN-SHENG REN ET AL: "Corrosion behaviour of TiN films prepared by vacuum arc deposition and nitrogen ion beam dynamic mixing implantation" SURFACE & COATINGS TECHNOLOGY ELSEVIER SWITZERLAND, vol. 185, no. 2-3, 22 juillet 2004 (2004-07-22), pages 210-214, XP002480653 ISSN: 0257-8972**

**Description**

L'invention a pour objet un procédé par bombardement ionique pour réduire voire supprimer la porosité de dépôts métalliques.

L'invention vise notamment à réduire, voire à supprimer la porosité de dépôts d'or, mais ne saurait être limitée à des dépôts de ce métal. Le procédé selon l'invention est également susceptible d'améliorer les propriétés de dépôts d'autres métaux, par exemple d'argent, de nickel, de platine, de zinc, d'étain ou d'alliages.

L'invention trouve notamment des applications dans le secteur de la connectique où l'on cherche à augmenter la durée de vie des connecteurs en limitant, voire en supprimant les risques de corrosion. Cette corrosion est généralement due à la porosité des couches d'or qui peuvent laisser passer des agents corrosifs présents dans l'air et qui sont susceptibles d'attaquer des substrats notamment en cuivre, ou en nickel, ou en zinc

L'or est un métal connu pour ses qualités d'inoxydabilité, son insensibilité aux agents corrosifs comme par exemple l'acide sulfurique. L'eau régale compte parmi les rares mélanges permettant l'attaque de l'or. L'or est un bon conducteur électrique. Sa conductivité est à peine moins bonne que celle du cuivre.

En raison de ses qualités, l'industrie de la connectique utilise massivement l'or comme un revêtement anti-corrosion pour protéger les connecteurs tout en maintenant leur aptitude à laisser passer le courant.

Certains connecteurs sont fabriqués à partir de bandes plates de cuivre, de zinc ou de nickel préalablement revêtues d'un dépôt d'or d'environ 0,8 $\mu$m.

Dans le domaine de la connectique, le dépôt d'or s'effectue le plus souvent par voie électrolytique.

Le dépôt d'or se présente alors sous la forme d'une structure lamellaire traversée par endroits par des pores débouchant qui ont pour effet de limiter, voire de détruire son pouvoir d'anticorrosion. La formation de ces pores est inhérente au procédé de déposition de l'or par la voie électrolytique. Ces pores ont tendance à se former d'autant plus facilement que l'épaisseur d'or est faible.

Actuellement, les dépôts d'or sont d'environ 0,8 $\mu$m et ont une porosité se traduisant par des pores dont les diamètres peuvent atteindre 1 $\mu$m.

Les connecteurs fonctionnent dans de l'air contenant généralement de faible quantité de $SO_2$, du $NO_2$ et de $Cl_2$. La porosité des dépôts d'or est susceptible de laisser passer ces agents corrosifs qui finissent par former sur la surface des connecteurs des produits de corrosion constitués de nitrure, de sulfate et de chlorure de cuivre, de nickel ou de zinc. L'apparition de ces produits de corrosion peut provoquer un dysfonctionnement du connecteur.

Pour une question économique l'industrie de la connectique cherche à réduire l'épaisseur des dépôts. Passer l'épaisseur d'or de 0,8 $\mu$m à 0,2 $\mu$m revient à diviser par 4 le coût du dépôt. Cet objectif se heurte à des contraintes techniques : on a pu noter de manière générale qu'une diminution de l'épaisseur du dépôt entraîne une plus grande porosité, ce qui a pour effet de réduire la durée de vie du connecteur.

L'industrie de la connectique est aujourd'hui en attente d'une solution qui permette de réduire l'épaisseur des dépôts d'or tout en réduisant voire en supprimant la perméabilité de ceux-ci aux agents corrosifs.

EP 1 595 972 A1 décrit un procédé de traitement ionique de durcissement de couches d'or avec un faisceau d'ions.

WO2005/085491 A2 décrit un procédé de traitement ionique d'une couche d'aluminium avec un faisceau d'ions azote d'une source à résonance cyclotronique électronique permettant de gommer des micro-rugosités.

Chun-sheng Ren et al, dans "Surface and Coatings Technology" 185 (2004) 210-214, décrit un procédé de traitement de nitruration du titane sous trois incidences différentes, une certaine incidence permettant de réduire la porosité de la couche.

L'invention a pour but de remédier aux limites, inconvénients et problèmes techniques exposées précédemment.

L'invention propose ainsi un procédé de traitement ionique de la porosité d'un dépôt métallique poreux déposé sur un substrat comprenant une étape où la surface dudit dépôt métallique est soumise à un faisceau (F) d'ions.

Il est ainsi possible de réduire voire supprimer la porosité des dépôts métalliques, notamment d'or dont sont revêtues par exemple les bandes de cuivre, de nickel ou de zinc utilisées dans la connectique.

Grâce au procédé de la présente invention, le traitement de la porosité des dépôts métalliques, notamment d'or, permet de conserver les propriétés électriques, thermiques et mécaniques initiaux.

Grâce au procédé de la présente invention, le traitement des dépôts métalliques, notamment d'or, permet de préserver la couleur initiale.

Grâce au procédé de la présente invention, le traitement des dépôts métalliques, notamment d'or, ne nécessite pas des temps de traitement qui soient longs.

Grâce au procédé de la présente invention, le traitement des dépôts métalliques, notamment d'or est peu coûteux et permet son utilisation dans un cadre industriel, son coût ne devant pas être rédhibitoire par rapport aux coûts d'autres procédés.

Selon un mode de réalisation, le faisceau d'ions est émis par une source à résonance cyclotronique (RCE).

Selon le mode de réalisation, l'angle d'incidence (α) du faisceau d'ions est compris entre un angle d'incidence minimum (α_m) et sensiblement 80°, où l'angle d'incidence (α) du faisceau est mesuré par rapport à la normale à la surface du dépôt métallique poreux à traiter et où l'angle d'incidence minimum (α_m) est déterminé en fonction du rayon (R) des pores et de l'épaisseur (e) du dépôt métallique à traiter selon la formule :

$$\alpha_m = \text{arc tg}(R/e)$$

Le choix de l'angle d'incidence dans la plage mentionnée permet d'optimiser les conditions de réarrangement de la matière du dépôt métallique poreux et les expériences menées par les inventeurs ont montré que, grâce à ce choix, il est possible de combler la porosité de dépôt métallique, notamment de dépôts d'or obtenus par la voie électrolytique.

Dans ces conditions, on constate que le réarrangement de la matière du dépôt métallique poreux est moins efficace que dans les conditions ci-dessus. Cette moindre efficacité peut être compensée par un réarrangement de la surface du substrat. En effet quand l'angle d'incidence du faisceau est sensiblement confondu avec la normale à la surface du dépôt métallique, les inventeurs ont pu constater que les ions du faisceau pouvaient se propager à travers les porosités du dépôt et atteindre le substrat. Cet effet est très significatif quand les pores sont de forme sensiblement cylindrique et débouchent à la surface du dépôt métallique et à la surface du substrat. Les ions interagissant avec le substrat sont alors susceptibles de permettre des implantations ioniques dans le substrat permettant d'améliorer ses propriétés de dureté et/ou de résistance à la corrosion.

Selon un mode de réalisation, le faisceau est orienté dans deux directions opposées par rapport à la normale à la surface du dépôt métallique poreux à traiter, dans un même plan sensiblement perpendiculaire à ladite surface.

Les inventeurs ont pu constater que dans ces conditions, l'efficacité du traitement des porosités est grandement amélioré par rapport à l'utilisation d'un faisceau orienté dans une seule direction.

Selon un autre mode de réalisation, le faisceau est orienté par rapport à la surface du dépôt métallique poreux selon une pluralité d'angles d'incidence et/ou une pluralité de plans sensiblement perpendiculaires à la surface du dépôt métallique à traiter.

Les inventeurs ont également pu constater que ce mode de réalisation permet d'améliorer très significativement l'efficacité du traitement.

Selon un mode de réalisation, combinant les deux modes de réalisation précédemment cités, le faisceau est orienté successivement selon un même angle d'incidence α, et selon quatre directions qui se déduisent par une rotation de 90° par rapport à l'axe perpendiculaire à la surface, à savoir par rapport à la normale à la surface du dépôt métallique à traiter.

Selon différents modes de réalisation qui peuvent être combinés :

- la dose totale d'ions implantés est calculée de manière à permettre au moins une fois le déplacement de chaque atome de métal dans la profondeur d'implantation ;

- le faisceau d'ions est constitué d'atomes ionisés où les atomes sont choisis parmi la liste constituée de l'Hélium (He), l'Azote (N), le Néon (Ne), l'Argon (Ar), le Krypton (Kr), le Xénon (Xe) ;

- la tension d'extraction du faisceau d'ions est supérieure ou égale à 10 kV;

- le dépôt métallique poreux est un dépôt électrolytique ;

- le dépôt métallique poreux est un dépôt d'or.

On note qu'afin de limiter le volume et la complexité des appareillages utilisés, il peut être souhaitable de limiter la tension d'extraction du faisceau d'ions à au plus 300 kV.

Sans vouloir être lié par une quelconque théorie scientifique, on peut proposer le mécanisme suivant pour rendre compte des effets avantageux du procédé selon l'invention : lorsqu'un ion accéléré entre dans un matériau, il cède par collision atomique une partie de son énergie aux atomes situés sur son passage. Ces atomes provoquent à leur tour des collisions qui assurent sous forme de cascade un brassage balistique du matériau.

Ce brassage balistique est d'autant plus efficace que l'ion incident est lourd. On évalue ce brassage balistique par le nombre de collisions par unité de parcours qu'un ion incident peut provoquer dans un matériau donné.

Par exemple pour un ion d'hélium implanté avec une énergie de 70 keV dans de l'or, on estime ce nombre à 0,015 atomes/Angstrom. Comme son parcours est de 4000 Angstrom dans l'or, l'ion d'hélium bouscule 60 atomes sur son passage. Un ion d'azote implanté avec une énergie de 70 keV dans de l'or bouscule 0,35 atome/Angstrom sur un parcours de 1800 Angstrom, soit 630 atomes. On constate que pour une même énergie, l'efficacité de l'ion d'azote est 10 fois supérieure à celle de l'hélium mais toutefois sur un parcours deux fois moins important.

Selon cet exemple et en s'appuyant sur ces chiffres on estime qu'une dose de 10 [16] ions d'hélium /cm$^2$ suffisent à bousculer 4 fois chaque atome d'or situé dans une épaisseur d'implantation de 4000 Angstrom. Pour la même dose d'ions d'azote on bouscule quarante fois chaque atome situé dans une épaisseur de 2000 Angstrom. Dans les deux cas ces doses sont suffisantes pour permettre brasser totalement la couche d'implantation et combler partiellement ou totalement les pores présents dans le dépôt d'or. Ces doses ne modifient pas la composition du dépôt d'or dans la mesure où elles ne représentent qu'environ 1 pour cent des atomes d'or.

A titre d'exemple, on constate que la porosité des dépôts d'or obtenus par voie électrolytique se présente comme une distribution de pores dont le diamètre peut varier de 0 à 1 $\mu$m au travers d'une épaisseur d'environ de 0,8 $\mu$m. On cherche à réduire ces épaisseurs à 0,2 $\mu$m.

Selon un mode de réalisation, le procédé de l'invention propose de traiter le dépôt d'or avec une dose d'ions qui permette de brasser au moins une fois l'épaisseur d'implantation. Les ions ont une énergie qui doit leurs permettre de traverser partiellement ou totalement le dépôt. Le traitement est d'autant plus efficace que la profondeur d'implantation, donc l'énergie des ions est élevée.

Les inventeurs ont en outre constaté qu'il peut être avantageux de réduire l'épaisseur d'or pour permettre à des ions d'azote de traiter non seulement le dépôt par brassage balistique mais également le substrat. En effet les ions d'azote implantés dans le substrat peuvent par leur action retarder la corrosion. A titre d'exemple on pourrait traiter avec des ions d'azote de 70 keV. On aurait alors un brassage balistique pour imperméabiliser le dépôt d'or de 0,1 $\mu$m et une barrière anticorrosion de 0,1 $\mu$m dans le substrat.

Selon un mode de réalisation, le procédé de l'invention propose de traiter le dépôt métallique, notamment d'or, avec quatre doses, sous un même angle d'incidence et successivement selon quatre directions qui se déduisent par une rotation de 90° par rapport à l'axe perpendiculaire à la surface. Chaque dose permet de préférence de bousculer au moins une fois les atomes contenus dans l'épaisseur du dépôt. L'angle d'incidence minimum du faisceau peut être déterminé de manière à ce que sa tangente est égale au rapport du rayon des pores par l'épaisseur du dépôt d'or. Par exemple si le rayon est de 0,5 $\mu$m et que l'épaisseur du dépôt est de 0,5 $\mu$m, le faisceau a un angle d'incidence d'au moins 45°. On observe alors une augmentation de l'efficacité du brassage balistique.

Selon différents modes de réalisation du procédé de l'invention, la stratégie d'implantation peut être la suivante :

- Pour les angles d'incidence élevés, autrement dit sensiblement rasants par rapport à la surface, on constate qu'il est préférable d'utiliser des ions légers comme l'hélium qui présente l'avantage de pénétrer plus profondément dans l'épaisseur apparente du dépôt et de limiter les risques de pulvérisation. Il est avantageux de veiller à ce que la dose d'ions d'hélium n'excède pas quelques pourcents pour limiter la modification de la composition du dépôt d'or d'un point de vue électrique, mécanique ou encore esthétique.

- Pour les angles d'incidence plus faibles il peut être préférable de choisir des ions plus lourds comme l'azote compte tenu de l'efficacité dont ils font preuve pour brasser le dépôt d'or. On réduit ainsi les temps de traitement. Dans ce cas les doses nécessaires sont faibles et il y a peu de risque de modifier les caractéristiques électriques, mécaniques ou encore esthétiques des dépôts.

- En outre, on constate qu'en diminuant l'épaisseur des dépôts d'or, on augmente le rayon moyen des pores. Pour le traitement on peut envisager d'évoluer progressivement de l'utilisation d'ions d'azote à des ions d'hélium dans la mesure où l'on augmente les angles d'incidences.

Pour augmenter l'efficacité du traitement tout en diminuant son coût, le procédé de l'invention préconise selon un mode de réalisation, l'utilisation de sources à résonance cyclotronique dite RCE. Ces sources ont pour particularité d'être compactes et de produire des ions multichargés, donc plus énergétiques pour une même tension d'extraction. De plus ces sources sont robustes et peu consommatrices en électricité. Compte tenu de leur taille, ces sources peuvent être disposées en série ou en parallèle pour multiplier la capacité de traitement des machines. Leurs intensités, de l'ordre de 10 mA, permettent des bandes de quelques mm de large à des vitesses de l'ordre de quelques mètres par minute. Ces vitesses de traitement sont acceptables pour l'industrie.

Le procédé de l'invention propose, à titre d'exemples, de traiter les porosités de dépôts d'or. Il peut être utilisé avec d'autres métaux qui connaissent des problèmes de porosité similaires.

L'énergie du faisceau d'ions est de préférence supérieure ou égale à 10 keV. Une telle énergie est sélectionnée car elle permet de créer des cascades d'atomes suite à l'impact des ions.

A titre d'exemple, on propose les conditions de traitement suivant :

- pour un dépôt d'or de 0,1 $\mu$m d'épaisseur, un faisceau d'azote perpendiculaire au dépôt et d'énergie de l'ordre de 60 keV, ou d'énergie supérieure, permet à la fois un brassage efficace et la traversée du dépôt;

- pour un dépôt d'or de 0,4 $\mu$m d'épaisseur, un faisceau d'hélium perpendiculaire au dépôt et d'énergie de l'ordre de 100 keV, ou d'énergie supérieure, permet à la fois un brassage efficace et la traversée du dépôt.

A titre d'exemple, le tableau 1 donne des exemples de choix de paramètres pour le traitement de porosité dans une couche d'or, en fonction de l'ion utilisé (Hélium ou Azote), de l'épaisseur, e, du dépôt d'or, du rayon, R, des pores à traiter. On reporte «$\alpha_m$» correspondant à l'angle d'incidence minimale, « L » correspondant au parcours de l'ion pour traverser le dépôt, « $E_{min}$» correspondant à l'énergie minimale à fournir pour traverser le dépôt, le ratio « A » correspondant au déplacement des atomes par Angstroem et par ion incident, la valeur « D » correspondant à la dose requise pour déplacer une fois chaque atome de l'épaisseur du dépôt (exprimée en $10^{16}$ ion par cm$^2$) et la valeur « ep » de l'épaisseur pulvérisée (en Angstroem). Les données mentionnées correspondent à des traitements avec une source RCE où la tension d'extraction est de 45 kV. On obtient ainsi des ions d'hélium He+ de 45 KeV et He2+ de 90 keV ou des ions d'azote principalement sous la forme N+ de 45 keV, N2+ de 90 keV, N3+ de 135 keV.

TABLEAU 1

| ion | e($\mu$m) | R($\mu$m) | $\alpha_m$(°) | L($\mu$m) | $E_{min}$(KeV) | A | D | ep (Å) |
|---|---|---|---|---|---|---|---|---|
| He | 0,1 | 0,1 | 45 | 0,14 | 20 | 0,03 | 2 | 10 |
| | | 0,5 | 78 | 0,50 | 100 | 0,03 | 2 | 10 |
| | | 0,8 | 82 | 0,80 | 200 | 0,03 | 2 | 10 |
| | 0,2 | 0,1 | 26 | 0,22 | 40 | 0,03 | 4 | 20 |
| | | 0,5 | 68 | 0,53 | 110 | 0,03 | 4 | 20 |
| | | 0,8 | 75 | 0,82 | 210 | 0,03 | 4 | 20 |
| | 0,4 | 0,1 | 14 | 0,41 | 75 | 0,03 | 8 | 40 |
| | | 0,5 | 51 | 0,64 | 150 | 0,03 | 8 | 40 |
| | | 0,8 | 63 | 0,89 | 300 | 0,03 | 8 | 40 |
| N | 0,1 | 0,1 | 45 | 0,14 | 60 | 0,3 | 0,2 | 10 |
| | | 0,5 | 78 | 0,50 | 350 | 0,3 | 0,2 | 10 |
| | | 0,8 | 82 | 0,80 | 600 | 0,3 | 0,2 | 10 |
| | 0,2 | 0,1 | 26 | 0,22 | 150 | 0,3 | 0,4 | 20 |
| | | 0,5 | 68 | 0,53 | 300 | 0,3 | 0,4 | 20 |
| | | 0,8 | 75 | 0,82 | 600 | 0,3 | 0,4 | 20 |
| | 0,4 | 0,1 | 14 | 0,41 | 300 | 0,3 | 0,8 | 40 |
| | | 0,5 | 51 | 0,64 | 400 | 0,3 | 0,8 | 40 |
| | | 0,8 | 63 | 0,89 | 700 | 0,3 | 0,8 | 40 |

En outre, les inventeurs ont pu constater qu'il peut être avantageux de limiter à environ 5% en concentration atomique, la quantité d'ions implantés, notamment dans le cas de l'hélium.

D'autres particularités et avantages de la présente invention apparaîtront dans la description ci-après d'exemples de réalisation non limitatifs en référence aux dessins annexés dans lesquels :

- la figure 1 est une vue schématique en coupe d'un dépôt métallique sur un substrat,

- la figure 2 est une vue schématique en coupe de la mise en oeuvre du procédé selon l'invention,

- la figure 3 est une vue de courbes potentiométriques d'échantillons traités selon l'invention et d'un échantillon comparatif,

- la figure 4 est une vue d'un dispositif pour mettre en oeuvre la présente invention.

Pour des raisons de clarté, les dimensions des différents éléments représentés sur ces figures ne sont pas nécessairement en proportion avec leurs dimensions réelles.

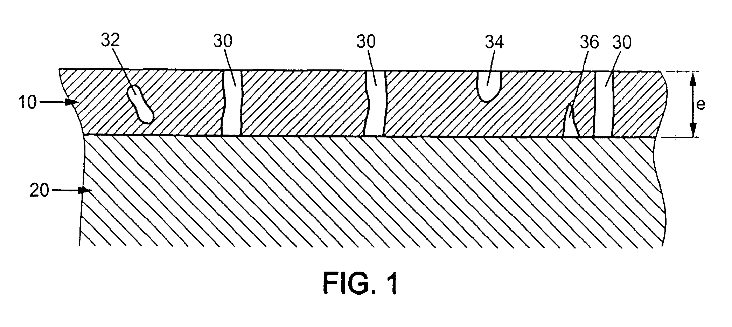

La figure 1 représente un dépôt métallique poreux 10, d'épaisseur e, déposé sur un substrat 20.

Plusieurs types de porosité peuvent exister dans le dépôt métallique poreux 10. Dans le cas de dépôts électrolytiques, on constate que les porosités se développent essentiellement dans une direction perpendiculaire à la surface du substrat sur laquelle le dépôt est effectué. A titre d'exemple, les porosités 30 sont sensiblement cylindriques et débouchent à la fois sur le substrat et à la surface extérieure du dépôt métallique. Des porosités 32, 36 sont des porosités fermées, formées respectivement au sein du dépôt métallique ou à l'interface avec le substrat.

Des porosités 34 sont des porosités débouchant à la surface extérieure du dépôt métallique, mais ne débouchant pas sur le substrat.

Les porosités 30 sont à même de laisser passer des agents corrosifs et de provoquer la corrosion du substrat.

Le procédé selon l'invention vise à combler ces porosités 30, mais est susceptible également de permettre des réarrangements de matière susceptibles de combler les porosités 32, 34, 36.

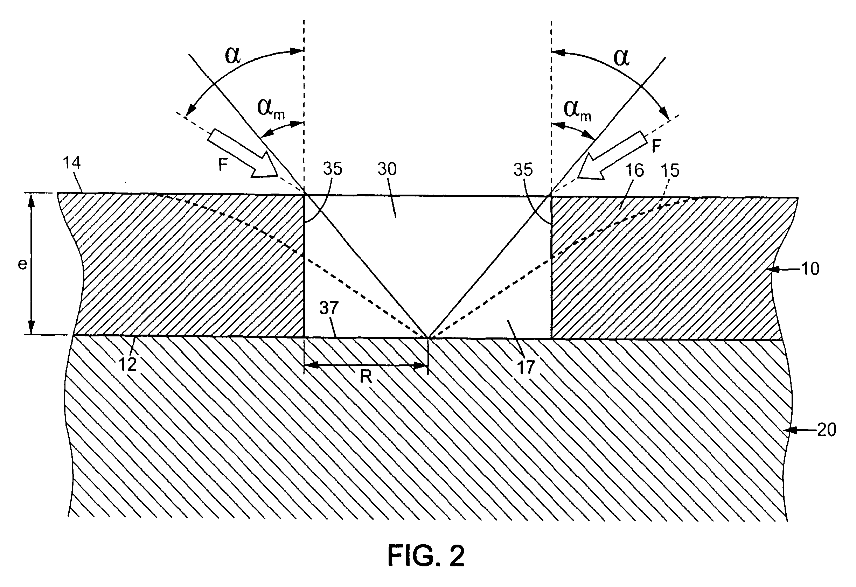

La figure 2 représente le traitement d'un pore avec un faisceau d'ions F.

Le dépôt métallique 10 est formé sur un substrat 20 et son épaisseur e est déterminée entre la face inférieure 12 dudit dépôt en contact avec le substrat et la face opposée extérieure 14. Un pore 30 est représenté, de forme cylindrique et limité par sa paroi 35 et son fond 37 correspondant à une zone du substrat 20 sur lequel est déposé le dépôt métallique 10.

Afin de combler, au moins partiellement, ce pore 30, un faisceau d'ions F est dirigé sur la surface 14 du dépôt. Le faisceau est orienté selon un angle $\alpha$, déterminé par rapport à la normale à la surface 14, où $\alpha$ est supérieur à un angle $\alpha_m$ d'incidence minimale qui a pour tangente le rapport du rayon R du pore par l'épaisseur e du dépôt métallique.

Quand les ions du faisceau F bombardent la surface 14, notamment selon l'incidence sélectionnée, les atomes situés en bord du pore sont brassés et susceptibles de venir combler le pore. On représente sous la forme pointillée le profil 15 du pore comblé par les atomes qui ont été brassés sur les bords du pore lors de l'implantation. Les atomes présents initialement dans la zone 16, située entre le profil 15 et la paroi 35 sont déplacés et viennent combler la zone 17 située entre le profil 15 et le fond initial 37 du pore. Dans l'exemple représenté, on soumet le dépôt métallique à deux faisceaux orientés selon un angle $\alpha$, dans un même plan perpendiculaire à la surface 14. On constate que cette configuration permet avantageusement de combler le pore 30.

On note que quand l'angle d'incidence est supérieur à l'angle d'incidence minimum, on comble avec plus d'efficacité le fonds du pore que quand l'angle d'incidence égale l'angle d'incidence minimum, mais il faut en contrepartie que l'énergie des ions soit suffisante pour traverser l'épaisseur apparente qui du même coup augmente.

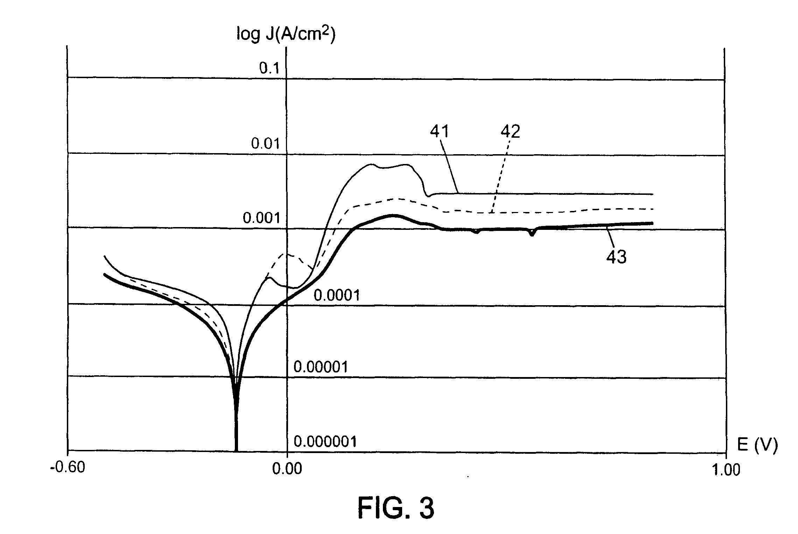

La figure 3 représente les courbes potentiometriques obtenues pour :

- un dépôt d'or vierge constituant un échantillon comparatif, courbe 41 ;

- un dépôt d'or traité selon l'invention par un faisceau d'azote perpendiculaire, courbe 42 ;

- un dépôt d'or traité selon l'invention par un faisceau d'hélium, courbe 43, sous un angle de 45° et selon quatre directions perpendiculaires.

Les dépôts d'or ont été effectués par voie électrolytique sur un substrat de nickel. L'or déposé a une épaisseur de 0,8 $\mu$m et correspond à de l'or pur.

La solution utilisée est du $H_2SO_4$ à 0,5 M. On constate la diminution du courant de corrosion d'un facteur 2 pour l'azote, d'un facteur 3 à 4 pour l'hélium. Dans les deux cas, cette diminution du courant de corrosion traduit la diminution de la porosité due au traitement. La dose implantée en azote est quatre fois supérieure à celle en l'hélium. On remarque toutefois une plus grande efficacité du traitement avec l'hélium. Ceci s'explique par l'optimisation du brassage balistique obtenu sous quatre directions perpendiculaires, et sous un même angle d'incidence de 45 °.

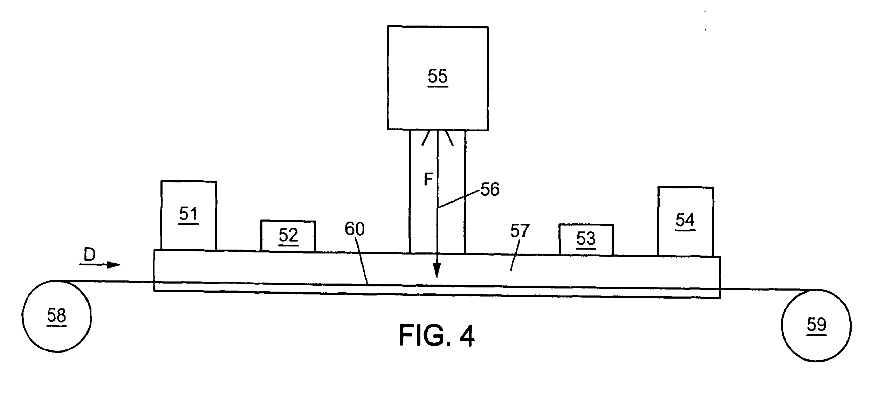

La figure 4 représente une machine de traitement par défilement de bande. La bande 60 est constituée d'un substrat et d'un dépôt métallique poreux à traiter.

Pour une machine de traitement par défilement de bande, il convient de placer une colonne de vide différentiel 56 entre la source RCE 55. En effet, un vide de $10^{-6}$ mbar est nécessaire à la production du plasma dans la source et un vide de $10^{-4}$ mbar est suffisant pour traiter la bande dans la chambre 57. La colonne de vide différentiel 56 à pour fonction de laisser passer le faisceau F tout en empêchant les remontées de gaz dans la chambre à plasma. La colonne de vide différentiel 56 est équipée d'un système de pompage turbomoléculaire permettant de piéger ces remontées de gaz. Deux sas, l'un en entrée, l'autre en sortie, sont équipés d'un système de pompage primaire 51 et 54 et turbomoléculaire 52 et 53 permettant de laisser passer la bande 60 et de créer un vide dans la chambre de traitement 57. La vitesse de déroulement de la bande sur le dérouleur/enrouler 58, 59 est calculée de manière à obtenir la dose requise pour traiter le dépôt métallique, notamment d'or supportée par la bande. Pour éviter un risque d'échauffement qui pourrait créer une rupture de la bande, on peut augmenter la vitesse de défilement et multiplier proportionnellement le nombre de passes en marche avant et marche arrière.

L'invention n'est pas limitée aux types de réalisation exemplifiées et doit être interprétée de façon non limitative et englobent tout mode de réalisation équivalent. Il convient de noter que si des exemples de dépôts par voie électrolytique ont été présentés, le procédé selon l'invention peut s'appliquer à tout type de dépôts métalliques, par exemple obtenus par voie gazeuse, tels que par exemple par CVD, PVD, ou toute autre technique adaptée à produire un dépôt métallique sur un substrat. Il convient également de noter que si des exemples de dépôts d'or ont été présentés, le procédé selon l'invention est également susceptible diminuer, voire de combler, la porosité de dépôts d'autres métaux, par exemple d'argent, de nickel, de platine, de zinc, d'étain ou d'alliages.

## Revendications

1. Procédé de traitement ionique de la porosité d'un dépôt métallique poreux (10) déposé sur un substrat (20) comprenant une étape où la surface dudit dépôt métallique est soumise à un faisceau (F) d'ions, **caractérisé en ce que** l'angle d'incidence ($\alpha$) du faisceau d'ions est compris entre un angle d'incidence minimum ($\alpha_m$) et sensiblement 80°, où l'angle d'incidence ($\alpha$) du faisceau est mesuré par rapport à la normale à la surface (14) du dépôt métallique poreux à traiter et où l'angle d'incidence minimum ($\alpha_m$) est déterminé en fonction du rayon (R) des pores et de l'épaisseur (e) du dépôt métallique à traiter selon la formule :

$$\alpha_m = arc\ tg(R/e)$$

2. Procédé de traitement selon la revendication précédente **caractérisé en ce que** le faisceau d'ions est émis par une source à résonance cyclotronique (RCE) (55).

3. Procédé de traitement selon l'une quelconque des revendications précédentes **caractérisé en ce que** le faisceau est orienté dans deux directions opposées par rapport à la normale à la surface (14) du dépôt métallique poreux à traiter, dans un même plan sensiblement perpendiculaire à ladite surface (14).

4. Procédé de traitement selon l'une quelconque des revendications précédentes **caractérisé en ce que** le faisceau est orienté par rapport à la surface (14) du dépôt métallique poreux selon une pluralité d'angles d'incidence et/ou une pluralité de plans sensiblement perpendiculaires à la surface (14) du dépôt métallique à traiter.

5. Procédé de traitement selon les revendications 3 et 4 **caractérisé en ce que** le faisceau est orienté successivement selon un même angle d'incidence $\alpha$, et selon quatre directions qui se déduisent par une rotation de 90° par rapport à l'axe perpendiculaire à la surface, à savoir par rapport à la normale à la surface (14) du dépôt métallique à traiter.

6. Procédé de traitement selon l'une quelconque des revendications précédentes **caractérisé en ce que** la dose totale d'ions implantés est calculée de manière à permettre au moins une fois le déplacement de chaque atome de métal dans la profondeur d'implantation.

7. Procédé de traitement selon l'une quelconque des revendications précédentes **caractérisé en ce que** le faisceau d'ions est constitué d'atomes ionisés où les atomes sont choisis parmi la liste constituée de l'Hélium (He), l'Azote (N), le Néon (Ne), l'Argon (Ar), le Krypton (Kr), le Xénon (Xe).

8. Procédé de traitement selon l'une quelconque des revendications précédentes **caractérisé en ce que** la tension d'extraction du faisceau d'ions est supérieure ou égale à 10 kV.

9. Procédé de traitement selon l'une quelconque des revendications précédentes **caractérisé en ce que** le dépôt métallique poreux (10) est un dépôt électrolytique.

10. Procédé de traitement selon l'une quelconque des revendications précédentes **caractérisé en ce que** le dépôt métallique poreux (10) est un dépôt d'or.

# EP 2 188 407 B1

**Claims**

1.  Method for ion treatment of the porosity of a porous metal deposit (10) deposited on a substrate (20) including a step in which the surface of said metal deposit is subjected to an ion beam (F) **characterized in that** the angle of incidence ($\alpha$) of the ion beam is between a minimum angle of incidence ($\alpha_m$) and substantially 80°, in which the angle of incidence ($\alpha$) of the beam is measured with respect to the normal to the surface (14) of the porous metal deposit to be treated and in which the minimum angle of incidence ($\alpha_m$) is determined according to the radius (R) of the pores and the thickness (e) of the metal deposit to be treated according to the formula:

$$\alpha_m = \text{arc tg}(R/e).$$

2.  Treatment method according to the previous claim, **characterized in that** the ion beam is emitted by a cyclotron resonance source (ECR) (55).

3.  Treatment method according to any one of the previous claims, **characterized in that** the beam is oriented in two opposite directions with respect to the normal to the surface (14) of the porous metal deposit to be treated, in the same plane substantially perpendicular to said surface (14).

4.  Treatment method according to any one of the previous claims, **characterized in that** the beam is oriented with respect to the surface (14) of the porous metal deposit according to a plurality of angles of incidence and/or a plurality of planes substantially perpendicular to the surface (14) of the metal deposit to be treated.

5.  Treatment method according to claims 3 and 4, **characterized in that** the beam is oriented successively according to the same angle of incidence $\alpha$, and according to four directions which are deduced by a 90° rotation with respect to the axis perpendicular to the surface, namely with respect to the normal to the surface (14) of the metal deposit to be treated.

6.  Treatment method according to any one of the previous claims, **characterized in that** the total dose of implanted ions is calculated so as to enable the movement of each metal atom in the implantation depth at least once.

7.  Treatment method according to any one of the previous claims, **characterized in that** the ion beam is formed by ionized atoms in which the atoms are chosen from the list consisting of helium (He), nitrogen (N), neon (Ne), argon (Ar), krypton (Kr) and xenon (Xe).

8.  Treatment method according to any one of the previous claims, **characterized in that** the ion beam extraction voltage is greater than or equal to 10 kV.

9.  Treatment method according to any one of the previous claims, **characterized in that** the porous metal deposit (10) is an electrolytic deposit.

10. Treatment method according to any one of the previous claims, **characterized in that** the porous metal deposit (10) is a gold deposit.


**Patentansprüche**

1.  Verfahren zur Ionenbearbeitung der Porosität einer porösen metallischen Ablagerung (10), die auf einem Substrat (20) abgelagert ist, das einen Schritt umfasst, in dem die Oberfläche der metallischen Ablagerung mit einem Ionenstrahlenbündel (F) beaufschlagt wird, **dadurch gekennzeichnet, dass** der Auftreffwinkel ($\alpha$) des Ionenstrahlen-bündels in einem Bereich zwischen einem minimalen Auftreffwinkel ($\alpha_m$) und im Wesentlichen 80° liegt, wobei der Auftreffwinkel ($\alpha$) des Strahlenbündels in Bezug auf die Normale der Oberfläche (14) der zu bearbeitenden porösen metallischen Ablagerung gemessen wird und wobei der minimale Auftreffwinkel ($\alpha_m$) als Funktion des Radius (R) der Poren und der Dicke (e) der zu bearbeitenden metallischen Ablagerung gemäß der folgenden Formel bestimmt wird:

$$\alpha_m = arc\ tg(R/e).$$

**2.** Bearbeitungsverfahren nach dem vorhergehenden Anspruch, **dadurch gekennzeichnet, dass** das Ionenstrahlenbündel von einer Zyklotronresonanzquelle (RCE) (55) emittiert wird.

**3.** Bearbeitungsverfahren nach einem der vorhergehenden Ansprüche, **dadurch gekennzeichnet, dass** das Strahlenbündel in zwei in Bezug auf die Normale der Oberfläche (14) der zu bearbeitenden porösen metallischen Ablagerung entgegengesetzten Richtungen in einer einzigen Ebene, die zu der Oberfläche (14) im Wesentlichen senkrecht ist, orientiert ist.

**4.** Bearbeitungsverfahren nach einem der vorhergehenden Ansprüche, **dadurch gekennzeichnet, dass** das Strahlenbündel in Bezug auf die Oberfläche (14) der porösen metallischen Ablagerung in mehreren Auftreffwinkeln und/ oder in mehreren zu der Oberfläche (14) der zu bearbeitenden metallischen Ablagerung im Wesentlichen senkrechten Ebenen orientiert ist.

**5.** Bearbeitungsverfahren nach den Ansprüchen 3 und 4, **dadurch gekennzeichnet, dass** das Strahlenbündel nacheinander unter demselben Auftreffwinkel α und in vier Richtungen orientiert wird, die sich durch Drehen um 90° in Bezug auf die Achse senkrecht zu der Oberfläche, d. h. in Bezug auf die Normale der Oberfläche (14) der zu bearbeitenden metallischen Ablagerung, ergeben.

**6.** Bearbeitungsverfahren nach einem der vorhergehenden Ansprüche, **dadurch gekennzeichnet, dass** die Gesamtdosis implantierter Ionen in der Weise berechnet wird, dass eine wenigstens einmalige Verlagerung jedes Atoms des Metalls in der Implantationstiefe möglich ist.

**7.** Bearbeitungsverfahren nach einem der vorhergehenden Ansprüche, **dadurch gekennzeichnet, dass** das Ionenstrahlenbündel aus ionisierten Atomen gebildet ist, wobei die Atome aus der Liste gewählt sind, die aus Helium (He), Stickstoff (N), Neon (Ne), Argon (Ar), Krypton (Kr) und Xenon (Xe) besteht.

**8.** Bearbeitungsverfahren nach einem der vorhergehenden Ansprüche, **dadurch gekennzeichnet, dass** die Extraktionsspannung für das Ionenstrahlenbündel größer oder gleich 10 kV ist.

**9.** Bearbeitungsverfahren nach einem der vorhergehenden Ansprüche, **dadurch gekennzeichnet, dass** die poröse metallische Ablagerung (10) eine elektrolytische Ablagerung ist.

**10.** Bearbeitungsverfahren nach einem der vorhergehenden Ansprüche, **dadurch gekennzeichnet, dass** die poröse metallische Ablagerung (10) eine Goldablagerung ist.

FIG. 1

**FIG. 2**

EP 2 188 407 B1

FIG. 3

EP 2 188 407 B1

FIG. 4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1595972 A1

- WO 2005085491 A2

**Littérature non-brevet citée dans la description**

- **Chun-sheng Ren et al.** *Surface and Coatings Technology,* 2004, vol. 185, 210-214